# EUROPEAN PATENT SPECIFICATION

(11) **EP 3 198 654 B1**
(45) Date of publication and mention of the grant of the patent: **07.04.2021**
(21) Application number: 15853675.5
(22) Date of filing: 15.07.2015
(51) Int. Cl.: H01L 31/0224, H01L 31/05, H01L 31/18

(54) **SOLAR CELL UNIT, SOLAR CELL ARRAY, SOLAR CELL MODULE AND MANUFACTURING METHOD THEREOF**
SOLARZELLENEINHEIT, SOLARZELLENANORDNUNG, SOLARZELLENMODUL UND HERSTELLUNGSVERFAHREN DAFÜR
UNITÉ DE CELLULE SOLAIRE, RÉSEAU DE CELLULES SOLAIRES, MODULE SOLAIRE ET LEUR PROCÉDÉ DE FABRICATION

(30) Priority: 31.10.2014 CN 201410608576; 31.10.2014 CN 201410606607; 31.10.2014 CN 201410606601; 31.10.2014 CN 201410606675; 31.10.2014 CN 201410608579; 31.10.2014 CN 201410608577; 31.10.2014 CN 201410608580; 31.10.2014 CN 201410606700; 31.10.2014 CN 201410608469; 17.02.2015 CN 201510085666; 30.04.2015 CN 201510218635; 30.04.2015 CN 201520277480 U
(43) Date of publication of application: 02.08.2017
(73) Proprietor: BYD Company Limited, Shenzhen, Guangdong 518118 (CN)
(72) Inventor: ZHAO, Zhiqiang, Shenzhen, Guangdong 518118 (CN); TIAN, Ye, Shenzhen, Guangdong 518118 (CN); WANG, Liguo, Shenzhen,Guangdong 518118 (CN); WANG, Shengya, Shenzhen, Guangdong 518118 (CN); JIANG, Zhanfeng, Shenzhen, Guangdong 518118 (CN); HE, Long, Shenzhen, Guangdong 518118 (CN)
(74) Representative: Hoffmann Eitle
(86) International application number: PCT/CN2015/084105
(87) International publication number: WO 2016/065951

(56) References cited:
- CN-A- 102 479 857
- CN-U- 202 721 140
- CN-U- 202 871 835
- US-A1- 2010 000 602
- SCHINDLER S., SCHNEIDER J., POENISCH C., NISSLER R., HABERMANN D.: "Soldering process and material characterization of miniaturized contact structures of newly developed multi busbar cell metallization concept", PROCEEDINGS / EU PVSEC 2013, 28TH EUROPEAN PHOTOVOLTAIC SOLAR ENERGY CONFERENCE AND EXHIBITION, PARC DES EXPOSITIONS PARIS NORD VILLEPINTE, PARIS, FRANCE, CONFERENCE 30 SEPTEMBER - 04 OCTOBER 2013, EXHIBITION 1- 3 OCTOBER 2013, 16 December 2013 (2013-12-16), XP040634879, ISBN: 978-3-936338-33-1
- JOHANN WALTER ET AL: "Multi-wire Interconnection of Busbar-free Solar Cells", ENERGY PROCEDIA, vol. 55, 1 January 2014 (2014-01-01), pages 380-388, XP055406988, NL ISSN: 1876-6102, DOI: 10.1016/j.egypro.2014.08.109
- S Braun ET AL: "The Multi-Busbar Design: an Overview Optimized Solar Cell Design for Module Integration*", 4 th Metallization Workshop, May 8 th 2013, Konstanz, 8 May 2013 (2013-05-08), XP055407005, Retrieved from the Internet: URL:http://www.metallizationworkshop.eu/fi leadmin/metallizationworkshop/docs/present ations2013/Session_VI_Braun.pdf [retrieved on 2017-09-15]
- M Stietka ET AL: "Wire Cell: A More Efficient Silicon Solar Cell and Module", The compiled state-of-the-art of PV solar technology and deployment : 23rd European Photovoltaic Solar Energy Conference, EU PVSEC ; proceedings of the international conference, held in Valencia, Spain, 1 - 5 September 2008, 5 September 2008 (2008-09-05), XP055407042, DE DOI: 10.4229/23rdEUPVSEC2008-1CV.2.33 ISBN: 978-3-936338-24-9 Retrieved from the Internet: URL:http://www.ati.ac.at/fileadmin/files/r esearch_areas/neqp/soze/Valencia2008_1CV.2 .33.pdf [retrieved on 2017-09-15]

## Description

### FIELD

The present disclosure relates to a field of solar cells, and more particularly, to a solar cell unit, a solar cell array, a solar cell module and a manufacturing method thereof.

### BACKGROUND

A solar cell module is one of the most important components of a solar power generation device. Sunlight irradiates onto a cell from its front surface and is converted to electricity within the cell. :Primary grid lines and secondary grid lines are disposed on the front surface, and then a welding strip covering and welded on the primary grid lines outputs current. The welding strip, the primary grid lines and the secondary grid lines cover part of the front surface of the cell, which blocks out part of the sunlight, and the part of sunlight irradiating onto the welding strip, the primary grid lines and the secondary grid lines cannot be converted into electric energy. Thus, the welding strip, the primary grid lines and the secondary grid lines need to be designed as fine as possible in order for the solar cell module to receive more sunlight. However, the welding strip, the primary grid lines and the secondary grid lines serve to conduct current, and in terms of resistivity, the finer the welding strip, the primary grid lines and the secondary grid lines are, the smaller the conductive cross section area thereof is, which causes greater loss of electricity due to increased resistivity.. Therefore, the welding strip, the primary grid lines and the secondary grid lines shall be designed to achieve a balance between light blocking and electrical conduction, and to take the cost into consideration. Examples are disclosed in document SCHINDLER S., SCHNEIDER J., POENISCH C., NISSLER R., HABERMANN D.: "Soldering process and material characterization of miniaturized contact structures of newly developed multi busbar cell metallization concept", Proceedings/EU PVSEC 2013, 28th European Photovoltaic Solar Energy Conference and Exhibition, in document JOHANN WALTER ET AL: Multi-wire Interconnection of Busbar-free Solar Cells", Energy Procedia, vol. 55, 1 January 2014, and US 2010/000602 A1.

### SUMMARY

The present disclosure is based on discoveries and understanding of the applicant to the following facts and problems.

In prior art, the front surface of the solar cell is usually provided with the primary grid lines and the secondary grid lines to output the current generated by the photoelectric effect or photochemistry effect. In order to improve a efficiency of the solar cells, solar cell manufacturers conducted extensive research on how to increase the number of the primary grid lines. In prior art, the number of primary grid lines has been successfully increased from two to three, or even five.

However, in prior art, the primary grid lines are formed by printing a paste containing expensive silver, so the manufacturing cost is very high, and the increase of the silver primary grid lines absolutely causes an increase in cost. Moreover, the current silver primary grid line has a great width (for example, up to over 2mm), such that the increase of the silver primary grid lines will enlarge a shading area, and make the photoelectric conversion efficiency low.

Consequently, in order to lower the cost and reduce the shading area, in prior art, the silver primary grid lines printed on the cells are replaced with metal wires, such as copper wires which serve as the primary grid lines to output the current. Since the silver primary grid lines are no longer used, the cost can be reduced considerably; the diameter of the copper wire is relatively small, so the shading area can be decreased. Thus, the number of the primary grid lines can be further increased up to 10. This kind of cell may be called a cell without primary grid lines, in which the metal wires replace the silver primary grid lines and welding strips of the traditional solar cell.

After extensive research, the inventor of the present disclosure finds if a cell is manufacture in a way that multiple parallel metal wires are drawn simultaneously, cut off, and then welded to the cell simultaneously, due to limitations of sophistication of equipment and process, for example, the influence of stress, the solar cell is bent to some extent when disposed at a free state, so the metal wire needs to remain strained to flatten the cell (a test proves that the minimum strain is at least 2N for a copper wire with a diameter of 0.2mm). In order to keep the strain, each metal wire needs to be provided with clips or similar equipment at two ends thereof, and the equipment occupies certain space, but the space in the cell is limited. Thus, in the prior art, at most ten metal wires can be drawn, fixed and welded to a single cell, and it will be difficult to increase the number of the metal wires. The larger the number of the metal wires is, the more free ends there are, such that the equipment needs to control more metal wires at the same time, which is demanding as for the wiredrawing equipment. Moreover, the space of the solar cells is limited. For example, the dimension of a single cell is 156mm× 156mm. In such limited space, the multiple metal wires need to be controlled accurately at the same time, which is demanding as for the equipment, especially as for the accuracy. Currently, it is still hard to control and weld multiple metal wires simultaneously in actual production, so the number of the conductive wires is limited, usually at most ten around, which is difficult to realize.

In order to solve the above problem, relevant patents (US20100275976 and US20100043863) provide a technical solution that multiple metal wires are fixed on a transparent film. That's to say, multiple parallel metal wires are fixed on the transparent film by adhesion; then, the transparent film bound with the multiple parallel metal wires is attached to the cell; finally the metal wires contact with the secondary grid lines on the cell by lamination. By this method, the multiple metal wires are fixed via the transparent film, which solves the problem of controlling the multiple metal wires simultaneously, and further increases the number of the metal wires. However, the technical solution almost abandons the welding process. That's to say, the metal wires are not connected with the secondary grid lines by the welding process; instead, the metal wires contact with the secondary grid lines by the laminating process, so as to output the current.

The above technical solution can further increase the number of the metal wires, but the transparent film may affect the light absorption, which causes kind of shading, and thus lowers the photoelectric conversion efficiency.

Furthermore, the above technical solution cannot connect the metal wires with the secondary grid lines by the welding process, because the melting temperature of the transparent film must be higher than the welding temperature (usually around 140°C), otherwise the transparent film will melt in the process of welding, which may lose the function of fixing the metal wires, and then the metal wires drift, resulting in poor welding effects.

Moreover, it is known to those skilled in the art that the solar cells in use are sealed to prevent moisture and air from penetrating into the cells, which may cause corrosion and short circuit. The encapsulating material at present is EVA whose melting point is 70°C to 80°C, much lower than the welding temperature. If the welding process is employed, as said above, the melting temperature of the transparent film must be higher than the welding temperature, which is higher than the melting point of the encapsulating material. Thus, in the encapsulating process, the encapsulating material (EVA) will melt at the encapsulating temperature, but the transparent film will not, such that the melting encapsulating material cannot penetrate the solid transparent film to completely seal the cells. Hence, the sealing effect is poor, and the actual product tends to fail. In terms of encapsulating, the melting temperature of the transparent film needs to be lower than the welding temperature, which is an evident paradox.

Therefore, the technical solution of fixing the metal wires via the transparent film cannot adopt the welding process to weld the metal wires with the secondary grid lines, or the metal wires are merely in contact with the secondary grid lines on the cells, i.e. the metal wires are only placed on the secondary grid lines. Thus, the connection strength of the metal wires and the secondary grid lines is so low that the metal wires tend to separate from the secondary grid lines in the laminating process or in use, which causes bad contact, low efficiency of the cells, or even failure thereof. Consequently, the product in this technical solution is not promoted and commercialized. There is no fairly mature solar cell without primary grid lines.

Moreover, in solar cell without primary grid lines, since the conductive wires are metal wires of very small diameter, the welding of the conductive wires and the secondary grid lines is relatively difficult, which may cause insufficient welding and bad contact. In the process of welding, the metal wire needs to be strained to some extent, i.e. being in a straight state, so there is an internal stress within the metal wire, therefore, after welded, the metal wire may tend to fall off, thereby lowering the efficiency of the cells considerably and even resulting in failure thereof.

The present disclosure seeks to solve at least one of the problems existing in the related art to at least some extent.

The solar cell with multiple primary grid lines provided in the present disclosure can be commercialized for mass production, and easy to manufacture with simple equipment, especially in low cost.

Thus, the present disclosure provides a solar cell unit that is easy to manufacture in low cost, and improves the photoelectric conversion efficiency.

Thus, the present disclosure provides a solar cell array that is easy to manufacture in low cost, and improves the photoelectric conversion efficiency.

Thus, the present disclosure provides a solar cell module with the above solar cell array, and the solar cell module is easy to manufacture in low cost, and improves the photoelectric conversion efficiency.

The present disclosure further provides a method for manufacturing the solar cell module.

Through extensive researches, the inventor of the present disclosure finds that when the metal wire is welded with the secondary grid lines on the cell substrate, there is great stress because the metal wire is too thin, such that the welding between the metal wire and the secondary grid lines is not solid. The metal wire may crack and fall in less than one month, and hence the cell can no longer be used. Moreover, the secondary grid lines involve the issue of shading surface, which may affect the light absorption rate. Therefore, the development of the technology is hindered.

According to a first aspect of embodiments of the present disclosure, a solar cell unit includes a cell which consists of a cell substrate and a secondary grid line disposed on a front surface of the cell substrate; a conductive wire intersected and welded with the secondary grid line, and the secondary grid line having a width in a welding position with the conductive wire greater than a width thereof in a non-welding position. The secondary grid line preferably has a width in the welding position greater than or equal to a diameter or width of the conductive wire. The secondary grid line has a width of 0.08-0.24 mm in the welding position, and a width of 0.015-0.03 mm in the non-welding position; the width of the secondary grid line is a maximum size in a direction orthogonal to a longitudinal direction of the secondary grid line, and/or the secondary grid line has a height of 0.01-0.03 mm in the welding position, and a height of 0.005-0.01 mm in the non-welding position, wherein binding force between the conductive wire and the cells ranges from 0.2 N to 0.6 N.

As for the solar cell unit according to embodiments of the present disclosure, the portion where the secondary grid lines are welded with the conductive wires is widen, while other portions are relatively narrow, which makes it easier to weld the conductive wires with the secondary grid lines more reliably, and to manufacture the welding portion, thereby reducing the cost. In addition, the connection strength of the conductive wires and the secondary grid lines is enhanced, and only the portion of the secondary grid line welded with the conductive wires needs to be broadened. In such a case, other portions of the secondary grid lines can be further narrowed, such that the shading area is decreased, which improves the photoelectric conversion efficiency of the solar cell.

According to a second aspect of embodiments of the present disclosure, a solar cell array includes a plurality of solar cell units which are the solar cell units according to the above embodiments, and cells of the adjacent cell units are connected by the conductive wires.

According to a third aspect of embodiments of the present disclosure, a solar cell module includes an upper cover plate, a front adhesive layer, a cell array, a back adhesive layer and a lower cover plate superposed in sequence, the cell array being a solar cell array according to the above embodiments.

According to a fourth aspect of embodiments of the present disclosure, a method for manufacturing a solar cell module includes: providing a cell which includes a cell substrate and a secondary grid line disposed on a front surface of the cell substrate; welding a conductive wire constituted by a metal wire with the secondary grid line to obtain a solar cell unit, in which the secondary grid line has a width in a welding position with the conductive wire greater than a width thereof in a non-welding position; superposing an upper cover plate, a front adhesive layer, the solar cell unit, a back adhesive layer and a lower cover plate in sequence, in which a front surface of the solar cell faces the front adhesive layer, a back surface thereof facing the back adhesive layer, and laminating them to obtain the solar cell module. The secondary grid line preferably has a width in the welding position greater than or equal to a diameter or width of the conductive wire. The secondary grid line has a width of 0.08-0.24 mm in the welding position, and a width of 0.015-0.03 mm in the non-welding position; the width of the secondary grid line is a maximum size in a direction orthogonal to a longitudinal direction of the secondary grid line, and/or the secondary grid line has a height of 0.01-0.03 mm in the welding position, and a height of 0.005-0.01 mm in the non-welding position, wherein a binding force between the metal wire and the cells ranges from 0.2 N to 0.6 N.

### BRIEF DESCRIPTION OF THE DRAWINGS

Fig. 1 is a plan view of a solar cell array according to an embodiment of the present disclosure;
Fig. 2 is a longitudinal sectional view of a solar cell array according to an embodiment of the present disclosure;
Fig. 3 is a transverse sectional view of a solar cell array according to embodiments of the present disclosure;
Fig. 4 is a schematic diagram of a metal wire for forming a conductive wire according to embodiments of the present disclosure;
Fig. 5 is a plan view of a solar cell array according to another embodiment of the present disclosure;
Fig. 6 is a plan view of a solar cell array according to another embodiment of the present disclosure;
Fig. 7 is a schematic diagram of a metal wire extending reciprocally according to embodiments of the present disclosure;
Fig. 8 is a schematic diagram of two cells of a solar cell array according to embodiments of the present disclosure;
Fig. 9 is a sectional view of a solar cell array formed by connecting, by a metal wire, the two cells according to Fig. 8;
Fig. 10 is a schematic diagram of a solar cell module according to embodiments of the present disclosure;
Fig. 11 is a sectional view of part of the solar cell module according to Fig. 10;
Fig. 12 is a schematic diagram of a solar cell array according to another embodiment of the present disclosure;
Fig. 13 is a schematic diagram of a secondary grid line of a solar cell according to an embodiment of the present disclosure.

### Reference numerals:

- 100: cell module
- 10: upper cover plate
- 20: front adhesive layer
- 30: cell array
- 31: cell
- 31A: first cell
- 31B: second cell
- 311: cell substrate
- 312: secondary grid line
- 312A: front secondary grid line
- 312B: back secondary grid line
- 3123: welding portion
- 313: back electric field
- 314: back electrode
- 32: conductive wire
- 32A: front conductive wire
- 32B: back conductive wire
- 321: metal wire body
- 322: welding layer
- 33: short grid line
- 40: back adhesive layer
- 50: lower cover plate

### DETAILED DESCRIPTION

Embodiments of the present disclosure will be described in detail and examples of the embodiments will be illustrated in the drawings, where same or similar reference numerals are used to indicate same or similar members or members with same or similar functions. The embodiments described herein with reference to the drawings are explanatory, which are used to illustrate the present disclosure, but shall not be construed to limit the present disclosure.

Part of technical terms in the present disclosure will be elaborated herein for clarity and convenience of description.

According to one embodiment of the present disclosure, a cell unit includes a cell 31 and conductive wires 32, so the conductive wires 32 can be called the conductive wires 32 of the cell unit.

A cell 31 includes a cell substrate 311, secondary grid lines 312 disposed on a front surface(the surface on which light is incident) of the cell substrate 311, a back electric field 313 disposed on a back surface of the cell substrate 311, and back electrodes 314 disposed on the back electric field 313. Thus, the secondary grid lines 312 can be called the secondary grid lines 312 of the cell 31, the back electric field 313 called the back electric field 313 of the cell 31, and the back electrodes 314 called the back electrodes 314 of the cell 31.

The cell substrate 311 can be an intermediate product obtained by subjecting, for example, a silicon chip to processes of felting, diffusing, edge etching and silicon nitride layer depositing. However, it shall be understood that the cell substrate 311 in the present disclosure is not limited to be formed by the silicon chip.

In other words, the cell 31 comprises a silicon chip, some processing layers on a surface of the silicon chip, secondary grid lines on a shiny surface (namely a front surface), and a back electric field 313 and back electrodes 314 on a shady surface (namely a back surface), or includes other equivalent solar cells of other types without any front electrode.

The cell unit, the cell 31 and the cell substrate 311 are used to illustrate the present disclosure, but shall not be construed to limit the present disclosure.

A solar cell array 30 is arranged by a plurality of cells, i.e. by a plurality of cells 31 connected by conductive wires 32.

In the solar cell array 30, a metal wire body 321 constitutes the conductive wire 32 of the cell unit, and extends between surfaces of the adjacent cells 31, which shall be understood in a broad sense that the metal wire body 321 may extend between surfaces of the adjacent cells 31, or may be connected with a secondary grid line 312 of the cell 31, or may be connected with a secondary grid line 312 of a first cell 31 and a back electrode 314 of a second cell 31 adjacent to the first cell 31, or a part of the metal wire body 321 is connected with the secondary grid line 312 and the other part of the metal wire body 321 is connected with a back electrode 314 of the cell 31.

That's to say, the metal wire body 321 can extend between front surfaces of adjacent cells 31, or extend between a front surface of a first cell 31 and a back surface of a second cell 31 adjacent to the first cell 31. When the metal wire body 321 extends between the front surface of the first cell 31 and the back surface of the second cell 31 adjacent to the first cell 31, the conductive wire 32 may include a front conductive wire 32A extending on the front surface of the cell 31 and electrically connected with the secondary grid lien 312 of the cell 31, and a back conductive wire 32B extending on the back surface of the cell 31 and electrically connected with the back electrode 314 of the cell 31. Part of the metal wire body 321 between the adjacent cells 31 can be called a connection conductive wire.

All the ranges disclosed in the present disclosure include terminals, and can be individual or combined. It shall be understood that the terminals and any value of the ranges are not limited to an accurate range or value, but also include values proximate the ranges or values.

In the present disclosure, the orientation terms such as "upper" and "lower" usually refer to the orientation "upper" or "lower" as shown in the drawings under discussion, unless specified otherwise; "front surface" refers to a surface of the solar cell module facing the light in practical application (for example, when the module is in operation), i.e. a shiny surface on which light is incident, while "back surface" refers to a surface of the solar cell module back to the light in practical application.

In the following, the solar cell will be described according to the embodiments of the present disclosure.

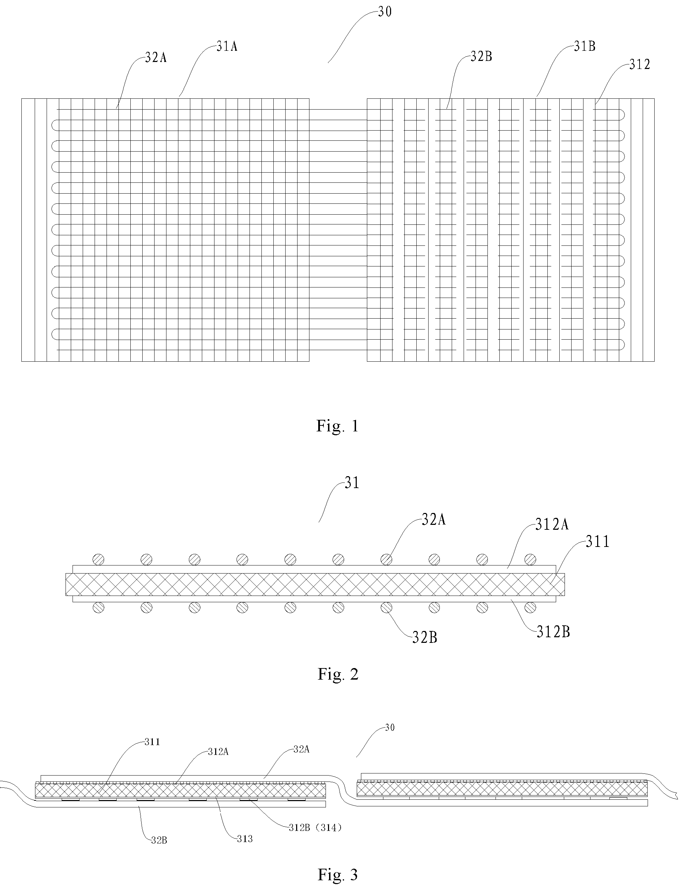

As shown in Fig. 1 to Fig. 13, the solar cell unit according to the embodiments of the present disclosure includes a cell 31 and conductive wires 32. The cell 31 consists of a cell substrate 311 and secondary grid lines 312 disposed on a front surface of the cell substrate 311; the conductive wires 32 are intersected and welded with the secondary grid lines 312, and the secondary grid lines have a width in a welding position with the conductive wire 32 greater than a width thereof in a non-welding position.

In other words, the solar cell unit according to the present disclosure is mainly formed with the cell 31 and conductive wires 32; the cell 31 is mainly constituted by the cell substrate 311 and secondary grid lines 312. In the present disclosure, the secondary grid lines 312 disposed on the front surface of the cell substrate 311 will be described in detail.

Specifically, as shown in Fig. 1, the secondary grid lines 312 are disposed on the front surface of the cell substrate 311 and extend in one direction. The conductive wires 32 are disposed on the secondary grid lines 312 and extend in another direction. The conductive wires 32 and the secondary grid lines 312 are welded at a portion where they are intersected. Usually, the conductive wires 32 are broader than the secondary grid lines 312, and the secondary grid lines 312 have a width in the welding portion with the conductive wire 32 greater than a width thereof in a non-welding portion.

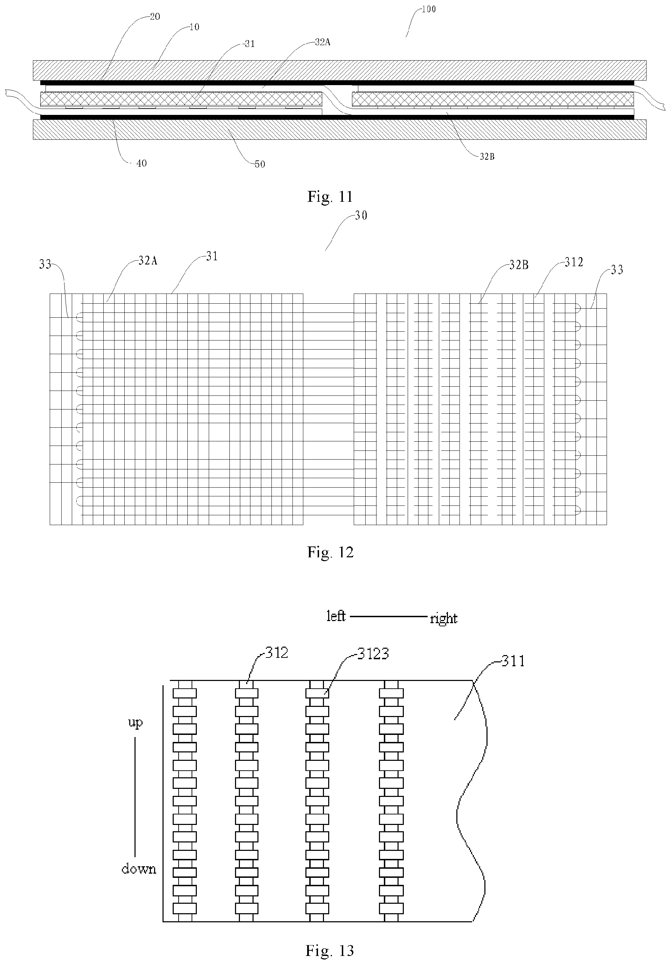

That's to say, as shown in Fig. 13, the secondary grid lines 312 are broadened in a position where the secondary grid lines 312 are intersected with the conductive wires 32, and the broadened part of the secondary grid lines 312 is taken as a welding portion 3123 to be welded with the conductive wires 32. The welding portion 3123 of the secondary grid lines 312 is broaden to facilitate welding the secondary grid lines 312 with the conductive wires 32. Meanwhile, other parts of the secondary grid lines 312 remain the original width, or even reduce the width, which cannot only guarantee the welding effect of the secondary grid lines 312 and the conductive wires 32, but also reduce the shading area.

Consequently, as for the solar cell according to the embodiments of the present disclosure, the portion where the secondary grid lines 312 are welded with the conductive wires 32 is widen, while other portions are relatively narrow, which makes it easier to weld the conductive wires 32 with the secondary grid lines 312, and to manufacture the welding portion, thereby reducing the cost. In such a case, the connection strength of the conductive wires 32 and the secondary grid lines 312 is enhanced, and the shading area is decreased, which improves the photoelectric conversion efficiency of the solar cell.

According to an embodiment of the present disclosure, the secondary grid lines 312 have a width in the welding position greater than or equal to a diameter or width of the conductive wires 32.

In other words, the welding portion 3123 of the secondary grid lines 312 has a line width larger than or equal to that of the conductive wires 32. Thus, the portion where the secondary grid lines 312 are welded with the conductive wires 32 is configured to have a line width larger than or equal to that of the conductive wires 32, so as to further enhance the connection strength of the conductive wires 32 and the secondary grid lines 312, and to facilitate welding to reduce the cost.

In some embodiments of the present disclosure, the conductive wires 32 are constituted by the metal wire body 321. In some embodiments, preferably, the metal wire body 321 is a copper wire, but the present disclosure is not limited thereto. For example, the metal wire body 321 can be an aluminum wire. Preferably, the metal wire body 321 has a circular cross section, such that more sunlight can irradiate the cell substrate to further improve the photoelectric conversion efficiency.

Further, the metal wire body 321 is coated with a welding layer 322 at least at a part welded with the secondary grid lines 312, and the conductive wires 32 are welded with the secondary grid lines 312 via the welding layer 322.

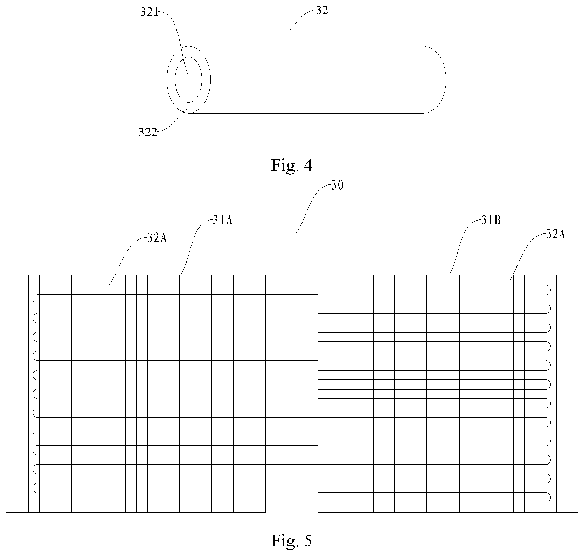

More preferably, as shown in Fig. 4, the metal wire body 321 is coated with a welding layer 322, such as a conductive adhesive layer or a welding layer. The metal wire is welded with the secondary grid line and/or the back electrode by the welding layer, such that it is convenient to electrically connect the metal wire body 321 with the secondary grid lines 312, and to avoid drifting of the metal wire in the connection process so as to guarantee the photoelectric conversion efficiency. Of course, the electrical connection of the metal wire body 321 with the cell 31 can be conducted when or before the solar cell module is laminated, and preference is given to the latter.

In some other embodiments of the present disclosure, the secondary grid lines 312 are coated with a welding layer by which the conductive wires 32 are welded with the secondary grid lines 312.

That's to say, the conductive wires 32 and the secondary grid lines 312 can be welded by arranging the welding layer on the conductive wires 32 or on the secondary grid lines 312. When the welding layer is disposed on the secondary grid lines 312, only the welding point on the secondary grid lines 312 is usually provided with the welding layer, so as to guarantee the effect of welding the conductive wires 32 with the secondary grid lines 312, and to avoid the influence on the shading area to guarantee the photoelectric conversion efficiency.

According to an embodiment of the present disclosure, the secondary grid line 312 has a width of 0.08-0.24mm in the welding position, and a width of 0.015-0.03mm in the non-welding position; the width of the secondary grid line 312 is a maximum size in a direction orthogonal to a longitudinal direction of the secondary grid line 312.

Specifically, the secondary grid lines 312 extend in an up-to-down direction (as shown in Fig. 13), while the conductive wires 32 extend in a right-to-left direction (not shown in Fig. 13 which mainly describes the secondary grid lines, no need for conductive wires), and the conductive wires 32 and the secondary grid lines 312 are vertically intersected. The width of the secondary grid line 312 refers to its size in the right-to-left direction; the width of the welding portion 3123 of the secondary grid line 312 also refers to its width in the right-to-left direction.

In the embodiment, the welding portion 3123 of the secondary grid line 312 has a width of 0.08-0.24mm, and other parts of the secondary grid line 312 have a width of 0.015-0.03mm. For the secondary grid line 312 of this structure, the area of a single welding portion 3123 can be increased, so as to improve peel strength and reduce the shading area of the secondary grid lines 312. Moreover, the amount of silver is decreased, which not only improve the photoelectric conversion efficiency, but also lower the cost.

Alternatively, in some other specific embodiments of the present disclosure, the secondary grid line 312 has a height of 0.01-0.03mm in the welding position, and a height of 0.005-0.01mm in the non-welding position.

In other words, the secondary grid line 312 increases both width and thickness at the welding portion 3123. Hence, the secondary grid line 312 of this structure can further the stability of connection with the conductive wire 32, so as to enhance the peel strength of the conductive wire 32.

In the following, the solar cell array 30 will be described according to the embodiments of the present disclosure.

According to the embodiments of the present disclosure, the solar cell array 30 includes a plurality of solar cell units which are the solar cell units according to the above embodiment, cells 31 of adjacent cell units being connected by the conductive wires 32.

Since the solar cell unit according to the above embodiment of the present disclosure has the above technical effect, the solar cell array 30 according to the embodiment of the present disclosure has the corresponding technical effect, i.e. making it easier to weld the conductive wires 32 with the secondary grid lines 312 of the cell 31 of the adjacent solar cell, and to manufacture the welding portion, thereby reducing the cost. In such a case, the connection strength of the conductive wires 32 and the secondary grid lines 312 is enhanced, and the shading area is decreased, which improves the photoelectric conversion efficiency of the solar cell.

Specifically, in some embodiments of the present disclosure, the conductive wires are constituted by the metal wire body 321 which extends reciprocally between a surface of a first cell 31 and a surface of a second cell 31 adjacent to the first cell 31.

The cell unit is formed by the cell 31 and the conductive wires 32 constituted by the metal wire S which extends on the surface of the cell 31. In other words, the solar cell array 30 according to the embodiments of the present disclosure are formed with a plurality of cell units; the conductive wires 32 of the plurality of cells are formed by the metal wire body 321 which extends reciprocally between the surfaces of the cells 31.

It shall be understood that the term "extending reciprocally" in the application can be called "winding" which refers to that the metal wire body 321 extends between the surfaces of the cells 31 along a reciprocal route.

In the present disclosure, it shall be understood in a broad sense that "the metal wire body 321 extends reciprocally between surfaces of the cells 31. For example, the metal wire body 321 may extend reciprocally between a front surface of a first cell 31 and a back surface of a second cell 31 adjacent to the first cell 31; the metal wire body 321 may extend from a surface of the first cell 31 through surfaces of a predetermined number of middle cells 31 to a surface of the last cell 31, and then extends back from the surface of the last cell 31 through the surfaces of a predetermined number of middle cells 31 to the surface of the first cell 31, extending reciprocally like this.

In addition, when the cells 31 are connected in parallel by the metal wire body 321, the metal wire body 321 can extend on front surfaces of two cells, such that the metal wire body 321 constitutes front conductive wires 32A of the two cells connected in parallel. Alternatively, a first metal wire body 321 extends reciprocally between the front surfaces of the cells, and a second metal wire body 321 extends reciprocally between the back surfaces of the cells, such that the first metal wire body 321 constitutes front conductive wires 32A, and the second metal wire body 321 constitutes back conductive wires 32B.

When the cells 31 are connected in series by the metal wire body 321, the metal wire body 321 can extend reciprocally between a front surface of a first cell 31 and a back surface of a second cell 31 adjacent to the first cell 31, such that part of the metal wire body 321 which extends on the front surface of the first cell 31 constitutes front conductive wires 32A, and part thereof which extends on the back surface of the second cell 31 constitutes back conductive wires 32B. In the present disclosure, unless specified otherwise, the conductive wires 32 can be understood as the front conductive wires 32A, the back conductive wires 32B, or the combination thereof.

The term "extending reciprocally" can be understood as that the metal wire body 321 extends reciprocally once to form to two conductive wires 32 which form a U-shape or V-shape structure by the metal wire body 321 extending reciprocally, yet the present disclosure is not limited to the above.

In the solar cell array 30 according to the embodiments of the present disclosure, a plurality of conductive wires 32 of the cell units are constituted by the metal wire body 321 which extends reciprocally; and the adjacent cells 31 are connected by the conductive wires 32. Hence, the conductive wires 32 of the cell units in the present disclosure are used to output the current, and are not necessarily printed by expensive silver paste, and can be manufactured in a simple manner without using a solder strip to connect the cells. It is easy and convenient to connect the metal wire body 321 with the secondary grid line and the back electrode, so that the cost of the cells is reduced considerably.

Moreover, since the conductive wires 32 are constituted by the metal wire body 321 which extends reciprocally, the width of the conductive wires 32 (i.e. the width of projection of the metal wire on the cell) is much smaller than that of the current primary grid lines printed by silver paste, thereby decreasing the shading area. Further, the number of the conductive wires 32 can be adjusted easily, and thus the resistance of the conductive wires 32 is reduced, compared with the conductive wires made of the silver paste, and the efficiency of photoelectric conversion is improved. Since the metal wire body 321 extends reciprocally to form the conductive wires, when the cell array 30 is used to manufacture the solar cell module 100, the metal wire body 321 is easier to control accurately and will not tend to shift, i.e. the metal wire is not easy to "drift", which will not affect but further improve the photoelectric conversion efficiency.

Therefore, the solar cell array 30 according to the embodiments of the present disclosure has low cost and high photoelectric conversion efficiency.

In the following, the solar cell array 30 according to specific embodiments of the present disclosure will be described with reference to the drawings.

The solar cell array 30 according to a specific embodiment of the present disclosure is illustrated with reference to Fig. 1 to Fig. 3.

In the embodiment shown in Fig. 1 to Fig. 3, two cell units in the solar cell array 30 are shown. In other words, it shows two cells bodies 31 connected with each other via the conductive wire 32 constituted by the metal wire body 321.

It can be understood that the cell 31 comprises a cell substrate 311, a secondary grid line 312 (a front secondary grid line 312A) disposed on a front surface of the cell substrate 311, a back electric field 313 disposed on a back surface of the cell substrate 311, and a back electrode 314 disposed on the back electric field 313. In the present disclosure, it can be understood that the back electrode 314 may be a back electrode of a traditional cell, for example, printed by the silver paste, or may be a back secondary grid line 312B similar to the secondary grid line on the front surface of the cell substrate, or may be multiple discrete welding portions, unless specified otherwise. The secondary grid line refers to the secondary grid line 312 on the front surface of the cell substrate 311, unless specified otherwise.

Specifically, in an embodiment of the present disclosure, the metal wire body 321 extends reciprocally between a front surface of a first cell 31 and a back surface of a second cell 31.

As shown in Fig. 1 to Fig. 3, the solar cell array in the embodiment includes two cells 31A, 31B (called a first cell 31A and a second cell 31B respectively for convenience of description). The metal wire body 321 extends reciprocally between the front surface of the first cell 31A (a shiny surface, i.e. an upper surface in Fig. 2) and the back surface of the second cell 31B, such that the metal wire body 321 constitutes a front conductive wire of the first cell 31A and a back conductive wire of the second cell 31B. The metal wire body 321 is electrically connected with the secondary grid line of the first cell 31A (for example, being welded or bounded by a conductive adhesive), and electrically connected with the back electrode of the second cell 31B.

In an embodiment of the present disclosure, back electrodes 314 are disposed on the back surface of the cell substrate 311, and the metal wire body 321 is welded with the back electrodes 314.

That's to say, in the embodiment, front secondary grid lines 312A are disposed on the front surface of the cell substrate 311, and back electrodes 314 are disposed on the back surface thereof. When the conductive wires 32 are located on the front surface of the cell substrate 311, the conductive wires 32 are welded with the front secondary grid lines 312A; when the conductive wires 32 are located on the back surface of the cell substrate 311, the conductive wires 32 are welded with the back electrodes 314 on the back surface of the cell substrate 311.

In some embodiments, there is a metal wire body 321. The metal wire body 321 extends reciprocally between the first cell 31A and the second cell 31B for 1o to 60 times. Preferably, as shown in Fig. 1, the metal wire extends reciprocally for 12 times to form 24 conductive wires, and there is only one metal wire. In other words, a single metal wire extends reciprocally for 12 times to form 24 conductive wires, and the distance of the adjacent conductive wires can range from 2.5mm to 15mm. In this embodiment, the number of the conductive wires is increased, compared with the traditional cell, such that the distance between the secondary grid line and the conductive wire which the current runs through is decreased, so as to reduce the resistance and improve the photoelectric conversion efficiency. In the embodiment shown in Fig. 1, the adjacent conductive wires form a U-shape structure, for convenience of winding the metal wire. Alternatively, the present disclosure is not limited to the above. For example, the adjacent conductive wires form a V-shape structure.

In some embodiments, preferably, the metal wire is a copper wire, yet the present disclosure is not limited thereto. For example, the metal wire body 321 may be an aluminum wire. Preferably, the metal wire body 321 has a circular cross section, such that more sunlight can reach the cell substrate to further improve the photoelectric conversion efficiency.

More preferably, as shown in Fig. 4, the metal wire body 321 is coated with a welding layer 322. The metal wire is welded with the secondary grid line and/or the back electrode by the welding layer, such that it is convenient to electrically connect the metal wire with the secondary grid line and/or the back electrode, and to avoid drifting of the metal wire in the connection process so as to guarantee the photoelectric conversion efficiency. Of course, the electrical connection of the metal wire with the cell can be conducted when or before the solar cell module is laminated, and preference is given to the latter.

In some embodiments, preferably, before the metal wire contact the cell, the metal wire extends under a strain, i.e. straightening the metal wire. After the metal wire is connected with the secondary grid line and the back electrode of the cell, the strain of the metal wire can be released, so as to further avoid the drifting of the conductive wire when the solar cell module is manufacture, and to guarantee the photoelectric conversion efficiency.

Fig. 5 is a schematic diagram of a solar cell array according to another embodiment of the present disclosure. As shown in Fig. 5, the metal wire extends reciprocally between the front surface of the first cell 31A and the front surface of the second cell 31B, such that the metal wire constitutes front conductive wires at the front surfaces of the first cell 31A and the second cell 31B. In such a way, the first cell 31A and the second cell are connected in parallel. Of course, it can be understood that preferably the back electrode of the first cell 31A and the back electrode of the second cell 31B can be connected via a back conductive wire constituted by another metal wire which extends reciprocally. Alternatively, the back electrode of the first cell 31A and the back electrode of the second cell 31B can be connected in a traditional manner.

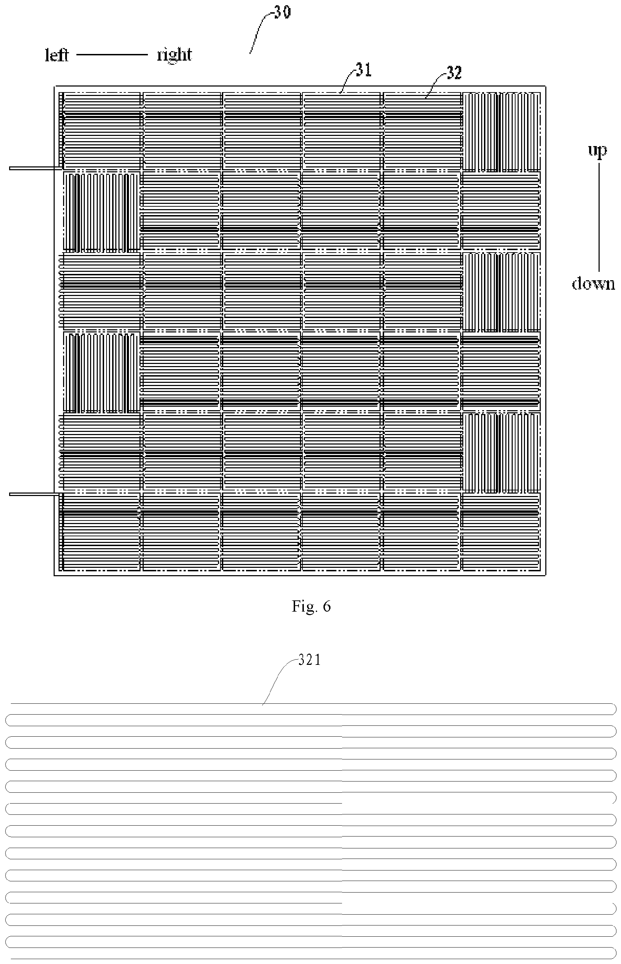

The solar cell array 30 according to another embodiment of the present disclosure is illustrated with reference to Fig.6.

The solar cell array 30 according to the embodiment of the present disclosure comprises n×m cells 31. In other words, a plurality of cells 31 are arranged in an n×m matrix form, n representing a column, and m representing a row. More specifically, in the embodiment, 36 cells 31 are arranges into six columns and six rows, i.e. n=m=6. It can be understood that the present disclosure is not limited thereto. For example, the column number and the row number can be different. For convenience of description, in Fig. 6, in a direction from left to right, the cells 31 in one row are called a first cell 31, a second cell 31, a third cell 31, a fourth cell 31, a fifth cell 31, and a sixth cell 31 sequentially; in a direction from up to down, the columns of the cells 31 are called a first column of cells 31, a second column of cells 31, a third column of cells 31, a fourth column of cells 31, a fifth column of cells 31, and a sixth column of cells 31 sequentially.

In a row of the cells, the metal wire extends reciprocally between a surface of a first cell 31 and a surface of a second cell 31 adjacent to the first cell 31; in two adjacent rows of cells 31, the metal wire extends reciprocally between a surface of a cell 31 in a a^{th} row and a surface of a cell in a (a+1)^{th} row, and m-1≥a≥1.

As shown in Fig. 6, in a specific example, in a row of the cells 31, the metal wire extends reciprocally between a front surface of a first cell 31 and a back surface of a second cell 31 adjacent to the first cell 31, so as to connect the cells in one row in series. In two adjacent rows of cells 31, the metal wire extends reciprocally between a front surface of a cell 31 at an end of the a^{th} row and a back surface of a cell 31 at an end of the (a+1)^{th} row, to connect the two adjacent rows of cells 31 in series.

More preferably, in the two adjacent rows of cells 31, the metal wire extends reciprocally between the surface of the cell 31 at an end of the a^{th} row and the surface of the cell 31 at an end of the (a+1)^{th} row, the end of the a^{th} row and the end of the (a+1)^{th} row located at the same side of the matrix form, as shown in Fig. 6, located at the right side thereof.

More specifically, in the embodiment as shown in Fig. 6, in the first row, a first metal wire extends reciprocally between a front surface of a first cell 31 and a back surface of the second cell 31; a second metal wire extends reciprocally between a front surface of the second cell 31 and a back surface of a third cell 31; a third metal wire extends reciprocally between a front surface of the third cell 31 and a back surface of a fourth cell 31; a fourth metal wire extends reciprocally between a front surface of the fourth cell 31 and a back surface of a fifth cell 31; a fifth metal wire extends reciprocally between a front surface of the fifth cell 31 and a back surface of a sixth cell 31. In such a way, the adjacent cells 31 in the first row are connected in series by corresponding metal wires.

A sixth metal wire extends reciprocally between a front surface of the sixth cell 31 in the first row and a back surface of a sixth cell 31 in the second row, such that the first row and the second row are connected in series. A seventh metal wire extends reciprocally between a front surface of the sixth cell 31 in the second row and a back surface of a fifth cell 31 in the second row; a eighth metal wire extends reciprocally between a front surface of the fifth cell 31 in the second row and a back surface of a fourth cell 31 in the second row, until a eleventh metal wire extends reciprocally between a front surface of a second cell 31 in the second row and a back surface of a first cell 31 in the second row, and then a twelfth metal wire extends reciprocally between a front surface of the first cell 31 in the second row and a back surface of a first cell 31 in the third row, such that the second row and the third row are connected in series. Sequentially, the third row and the fourth row are connected in series, the fourth row and the fifth row connected in series, the fifth row and the sixth row connected in series, such that the cell array 30 is manufacture. In this embodiment, a bus bar is disposed at the left side of the first cell 31 in the first row and the left side of the first cell 31 in the sixth row respectively; a first bus bar is connected with a conductive wire extending from the left side of the first cell 31 in the first row, and a second bus bar is connected with a conductive wire extending from the left side of the first cell 31 in the sixth row.

As said above, the cells in the embodiments of the present disclosure are connected in series by the conductive wires - the first row, the second row, the third row, the fourth row, the fifth row and the sixth row are connected in series by the conductive wires. As shown in Figs. Alternatively, the second and third row, and the fourth and fifth rows can be connected in parallel with a diode respectively to avoid light spot effect. The diode can be connected in a manner commonly known to those skilled in the art, for example, by a bus bar.

However, the present disclosure is not limited to the above. For example, the first and second rows can be connected in series, the third and fourth rows connected in series, the fifth and sixth rows connected in series, and meanwhile the second and third rows are connected in parallel, the fourth and fifth connected in parallel. In such a case, a bus bar can be disposed at the left or right side of corresponding rows respectively.

Alternatively, the cells 31 in the same row can be connected in parallel. For example, a metal wire extends reciprocally from a front surface of a first cell 31 in a first row through the front surfaces of the cells 31 in the second row to the sixth row.

Preferably, there is a metal wire extending reciprocally between adjacent cells 31 in a row; and there is a metal wire extending reciprocally between cells 31 in adjacent rows. Thus, adjacent cells 31 can be connected by a single metal wire that extends reciprocally for several times, which is easier to manufacture in lower cost.

In an embodiment of the present disclosure, the metal wire is coated with a welding layer. The ratio of the thickness of the welding layer and the diameter of the metal wire is (0.02-0.5): 1.

That's to say, in the cell array 30, the ratio of the thickness of the welding layer and the diameter of the conductive wire 32 (including the front conductive wire 32A and back conductive wire 32B) is (0.02-0.5): 1.

In the present disclosure, the conductive wires 32 (including the front conductive wires 32A and back conductive wires 32B) consist of a metal wire and a welding layer coating the metal wire. The welding layer may coat the metal wire completely or partially. When the welding layer coats the metal wire partially, the alloy layer is, preferably, formed at a position where the welding layer is welded with the secondary grid lines 312 of the cell 31. When the welding layer coats the metal wire completely, the welding layer can coat the periphery of the metal wire in a circular manner. The thickness of the welding layer can fall into a relatively wide range. Preferably, the welding layer has a thickness of 1 to 100µm, more preferably, 1 to 30µm.

The alloy with a low melting point for forming the welding layer may be a conventional alloy with a low melting point which can be 100 to 220°C. Preferably, the alloy with the low melting point contains Sn, and at least one of Bi, In, Ag, Sb, Pb and Zn, more preferably, containing Sn, Bi, and at least one of In, Ag, Sb, Pb and Zn.

Specifically, the alloy may be at least one of Sn-Bi alloy, In-Sn alloy, Sn-Pb alloy, Sn-Bi-Pb alloy, Sn-Bi-Ag alloy, In-Sn-Cu alloy, Sn-Bi-Cu alloy and Sn-Bi-Zn alloy. Most preferably, the alloy is Bi-Sn-Pb alloy, for example, containing 40 weight percent of Sn, 55 weight percent of Bi, and 5 weight percent of Pb (i.e. Sn40%-Bi55%-Pb5%). The thickness of the welding layer can be 0.001 to 0.06mm. The conductive wire 32 may have a cross section of 0.01 to 0.5mm². The metal wire can be conventional in the art, for example, a copper wire.

According to the present invention, the binding force between the metal wire and the cells ranges from 0.2N to 0.6N, so as to secure the welding between the cells and the metal wire, to avoid sealing-off of the cells in the operation and the transferring process and performance degradation due to poor connection, and to lower the cost.

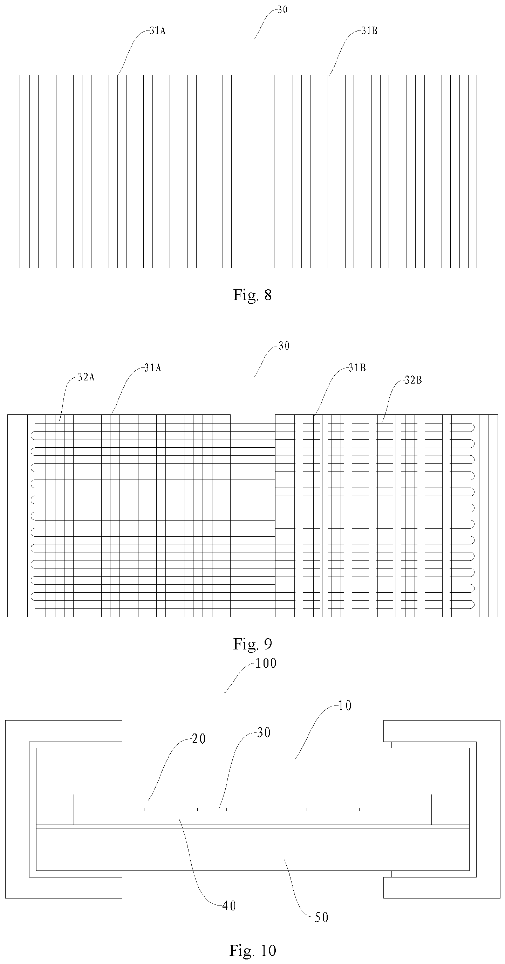

The solar cell module 100 according to embodiments of the present disclosure is illustrated with reference to Fig. 10 and Fig. 11.

As shown in Fig. 10 and Fig. 11, the solar cell module 100 according to embodiments of the present disclosure includes an upper cover plate 10, a front adhesive layer 20, the cell array 30, a back adhesive layer 40 and a lower cover plate 50 superposed sequentially along a direction from up to down.

The front adhesive layer 20 and the back adhesive layer 40 are adhesive layers commonly used in the art. Preferably, the front adhesive layer 20 and the back adhesive layer 40 are polyethylene-octene elastomer (POE) and/or ethylene-vinyl acetate copolymer (EVA). In the present disclosure, polyethylene-octene elastomer (POE) and/or ethylene-vinyl acetate copolymer (EVA) are conventional products in the art, or can be obtained in a method known to those skilled in the art.

In the embodiments of the present disclosure, the upper cover plate 10 and the lower cover plate 50 can be selected and determined by conventional technical means in the art. Preferably, the upper cover plate 10 and the lower cover plate 50 can be transparent plates respectively, for example, glass plates.

In the process of manufacturing the solar cell module 100, the conductive wire can be first welded with the secondary grid lines and the back electrode of the cell 31, and then superposed and laminated.

Other components of the solar cell module 100 according to the present disclosure are known in the art, which will be not described in detail herein.

Specifically, the solar module 100 includes an upper cover plate 10, a front adhesive layer 20, the cell array 30, a back adhesive layer 40 and a lower cover plate 50. The cell array 30 includes a plurality of cells 31, and adjacent cells 31 are connected by the plurality of conductive wires 32. The conductive wires 32 are constituted by the metal wire S which extends reciprocally between surfaces of adjacent cells. The conductive wires 32 are welded with the secondary grid lines. The front adhesive layer 20 contacts with the conductive wires 32 directly and fills between the adjacent conductive wires 32.

That's to say, the solar cell module 100 according to the present disclosure includes an upper cover plate 10, a front adhesive layer 20, the cell array 30, a back adhesive layer 40 and a lower cover plate 50 superposed sequentially along a direction from up to down. The cell array 30 includes a plurality of cells 31 and conductive wires 32 for connecting the plurality of cells 31. The conductive wires are constituted by the metal wire S which extends reciprocally between surfaces of two adjacent cells 31.

The conductive wires 32 are electrically connected with the cells 31, in which the front adhesive layer 20 on the cells 31 contacts with the conductive wires 32 directly and fills between the adjacent conductive wires 32, such that the front adhesive layer 20 can fix the conductive wires 32, and separate the conductive wires 32 from air and moisture from the outside world, so as to prevent the conductive wires 32 from oxidation and to guarantee the photoelectric conversion efficiency.

Thus, in the solar cell module 100 according to embodiments of the present disclosure, the conductive wires 32 constituted by the metal wire S which extends reciprocally replace traditional primary grid lines and solder strips, so as to reduce the cost. The metal wire S extends reciprocally to decrease the number of free ends of the metal wire S and to save the space for arranging the metal wire S, i.e. without being limited by the space. The number of the conductive wires 32 constituted by the metal wire which extends reciprocally may be increased considerably, which is easy to manufacture, and thus is suitable for mass production. The front adhesive layer 20 contacts with the conductive wires 32 directly and fills between the adjacent conductive wires 32, which can effectively isolate the conductive wires from air and moisture to prevent the conductive wires 32 from oxidation to guarantee the photoelectric conversion efficiency.

In some specific embodiments of the present disclosure, the metal wire S extends reciprocally between a front surface of a first cell and a back surface of a second cell adjacent to the first cell; the front adhesive layer 20 contacts with the conductive wires on the front surface of the first cell 31 directly and fills between the adjacent conductive wires 32 on the front surface of the first cell 31; the back adhesive layer 40 contacts with the conductive wires 32 on the back surface of the second cell 31 directly and fills between the adjacent conductive wires 32 on the back surface of the second cell 31.

In other words, in the present disclosure, the two adjacent cells 31 are connected by the metal wire S. In the two adjacent cells 31, the front surface of the first cell 31 is connected with the metal wire S, and the back surface of the second cell 31 is connected with the metal wire S.

The front adhesive layer 20 on the first cell 31 whose front surface is connected with the metal wire S is in direct contact with the metal wire S on the front surface of the first cell 31 and fills between the adjacent conductive wires 32. The back adhesive layer 40 on the second cell 31 whose back surface is connected with the metal wire S is in direct contact with the metal wire S on the back surface of the second cell 31 and fills between the adjacent conductive wires 32 (as shown in Fig. 2).

Consequently, in the solar cell module 100 according to the present disclosure, not only the front adhesive layer 20 can separate the conductive wires 32 on the front surfaces of part of the cells 31 from the outside world, but also the back adhesive layer 40 can separate the conductive wires 32 on the back surfaces of part of the cells 31 from the outside world, so as to further guarantee the photoelectric conversion efficiency of the solar cell module 100.

In some specific embodiments of the present disclosure, for a typical cell with a dimension of 156mm× 156mm, the solar cell module has a series resistance of 380 to 440mΩ per 60 cells. The present disclosure is not limited to 60 cells, and there may be 30 cells, 72 cells, etc. When there are 72 cells, the series resistance of the solar cell module is 456 to 528mΩ, and the electrical performance of the cells is better.

In some specific embodiments of the present disclosure, for a typical cell with a dimension of 156mm× 156mm, the solar cell module has an open-circuit voltage of 37.5-38.5V per 60 cells. The present disclosure is not limited to 60 cells, and there may be 30 cells, 72 cells, etc. The short-circuit current is 8.9 to 9.4A, and has nothing to do with the number of the cells.

In some specific embodiments of the present disclosure, the solar cell module has a fill factor of 0.79 to 0.82, which is independent from the dimension and number of the cells, and can affect the electrical performance of the cells.

In some specific embodiments of the present disclosure, for a typical cell with a dimension of 156mm× 156mm, the solar cell module has a working voltage of 31.5-32V per 60 cells. The present disclosure is not limited to 60 cells, and there may be 30 cells, 72 cells, etc. The working current is 8.4 to 8.6A, and has nothing to do with the number of the cells.

In some specific embodiments of the present disclosure, for a typical cell with a dimension of 156mm× 156mm, the solar cell module has a conversion efficiency of 16.5-17.4%, and a power of 265-280W per 60 cells.

A method for manufacturing the solar cell module 100 according to the embodiments of the present disclosure will be illustrated with respect to Fig. 7 to Fig. 9.

Specifically, the method according to the embodiments of the present disclosure includes the following steps:
providing a cell 31 which includes a cell substrate 311 and a secondary grid line 312 disposed on a front surface of the cell substrate 311;
welding a conductive wire 32 constituted by a metal wire with the secondary grid line 312 to obtain a solar cell, in which the secondary grid line 312 has a width in a welding position with the conductive wire 32 greater than a width thereof in a non-welding position;
superposing the upper cover plate 10, the front adhesive layer 20, the cell array 30, the back adhesive layer 40 and the lower cover plate 50 in sequence, in which the front surface of the cell 31 faces the front adhesive layer 20, and the back surface thereof faces the back adhesive layer 40, and laminating them to obtain the solar cell module 100.

The method includes the steps of preparing a solar array 30, superposing the upper cover plate 10, the front adhesive layer 20, the cell array 30, the back adhesive layer 40 and the lower cover plate 50 in sequence, and laminating them to obtain the solar cell module 100. It can be understood that the method further includes other steps, for example, sealing the gap between the upper cover plate 10 and the lower cover plate 50 by a sealant, and fixing the above components together by a U-shape frame, which are known to those skilled in the art, and thus will be not described in detail herein.

The method includes a step of forming a plurality of conductive wires by a metal wire which extends reciprocally surfaces of cells 31 and is electrically connected with the surfaces of cells 31, such that the adjacent cells 31 are connected by the plurality of conductive wires to constitute a cell array 30.

Specifically, as shown in Fig. 7, the metal wire extends reciprocally for 12 times under a strain. As shown in Fig. 8, a first cell 31A and a second cell 31B are prepared. As shown in Fig. 9, a front surface of the first cell 31A is connected with a metal wire, and a back surface of the second cell 31B is connected with the metal wire, such that the cell array 30 is formed. Fig. 9 shows two cells 31. When the cell array 30 has a plurality of cells 31, the metal wire which extends reciprocally connects the front surface of the first cell 31 and the back surface of the second cell 31 adjacent to the first cell 31, i.e. connecting a secondary grid line of the first cell 31 with a back electrode of the second cell 31 by the metal wire. The metal wire extends reciprocally under a strain from two clips at two ends thereof. The metal wire can be winded only with the help of two clips, which saves the clips considerably and then reduces the assembling space.

In the embodiment shown in Fig. 9, the adjacent cells are connected in series. As said above, the adjacent cells can be connected in parallel by the metal wire based on practical requirements.

The cell array 30 obtained is superposed with the upper cover plate 10, the front adhesive layer 20, the back adhesive layer 40 and the lower cover plate 50 in sequence, in which a front surface of the cell 31 faces the front adhesive layer 20, a back surface thereof facing the back adhesive layer 40, and laminating them to obtain the solar cell module 100. It can be understood that the metal wire can be bounded or welded with the cell 31 when or before they are laminated.

The front adhesive layer 20 is disposed in direct contact with the conductive wires 32. In the process of laminating, the front adhesive layer 20 melts and fills the gaps between adjacent conductive wires 32. The back adhesive layer 40 is disposed in direct contact with the conductive wires 32. In the process of laminating, the back adhesive layer 40 melts and fills the gaps between adjacent conductive wires 32.

Example 1 is used to illustrate the solar cell module 100 according to the present disclosure and the manufacturing method thereof.

### (1) Manufacturing a metal wire S

An alloy layer of Sn40%-Bi55%-Pb5% (melting point: 125°C) is attached to a surface of a copper wire, in which the copper wire has a cross section of 0.04mm², and the alloy layer has a thickness of 16µm. Hence, the metal wire S is obtained.

### (2) Manufacturing a solar cell module 100

A POE adhesive layer in 1630×980×0.5mm is provided (melting point: 65°C), and a glass plate in 1650×1000×3mm and a polycrystalline silicon cell 31 in 156×156×0.21mm are provided correspondingly. The cell 31 has 91 secondary grid lines, each of which substantially runs through the cell 31 in a longitudinal direction, and the distance between the adjacent secondary grid lines is 1.7mm. The cell 31 has five back electrodes (tin, 1.5mm in width, 10µm in thickness) on its back surface. Each back electrode substantially runs through the cell 31 in a longitudinal direction, and the distance between the adjacent back electrodes is 31mm.

The secondary grid lines 312 are made of silver, and provided with 15 welding portions to be welded with the conductive wires 32. The welding portions have a width of 80µm and a thickness of 10µm, and the non-welding portions have a width of 15µm and a thickness of 5µm.

60 cells 31 are arranged in a matrix form. In two adjacent cells 31 in a row, a metal wire extends reciprocally between a front surface of a first cell 31 and a back surface of a second cell 31 under a strain. The metal wire extends reciprocally under a strain from two clips at two ends thereof, so as to form 15 parallel conductive wires. The secondary grid lines of the first cell 31 are welded with the conductive wires and the back electrodes of the second cell 31 are welded with the conductive wires at a welding temperature of 160°C. The distance between parallel adjacent conductive wires is 9.9mm. 10 cells are connected in series into a row, and six rows of the cells of such kind are connected in series into a cell array via the bus bar.

Then, an upper glass plate, an upper POE adhesive layer, multiple cells arranged in a matrix form and welded with the metal wire, a lower POE adhesive layer and a lower glass plate are superposed sequentially from up to down, in which the shiny surface of the cell 31 faces the front adhesive layer 20, such that the front adhesive layer 20 contacts with the conductive wires 32 directly; and the shady surface of the cell 31 faces the back adhesive layer 40, and finally they are laminated in a laminator, in which the front adhesive layer 20 fills between adjacent conductive wires 32. In such way, a solar cell module A1 is obtained.

### Comparison example 1

The difference of Comparison example 1 and Example 1 lies in that the secondary grid lines 312 are not provided with any welding portion, and have a consistent width in the longitudinal direction, i.e. 15µm. The conductive wires 32 are welded with the secondary grid lines directly, so as to obtain a solar cell module D1.

### Example 2

The difference of Example 2 and Example 1 lies in that the welding portion on the secondary grid line has a width of 160µm and a thickness of 10µm; the non-welding portion has a width of 25µm and a thickness of 5µm, so as to obtain a solar cell module A2.

### Example 3

The difference of Example 3 and Example 1 lies in that the welding portion on the secondary grid line has a width of 240µm and a thickness of 10µm; the non-welding portion has a width of 30µm and a thickness of 5µm, so as to obtain a solar cell module A3.

### Example 4

The difference of Example 4 and Example 2 lies in that the welding portion on the secondary grid line has a thickness of 20µm; the non-welding portion has a thickness of 8pm, so as to obtain a solar cell module A4.

### Example 5

The difference of Example 5 and Example 2 lies in that the welding portion on the secondary grid line has a thickness of 30µm; the non-welding portion has a thickness of 10µm so as to obtain a solar cell module A5.

### Performance test

(1) Welding-binding force test
(2) The welding-binding force in the solar cell modules A1-A5 and D1 will be tested in the following method respectively:
   1. Placing the cell horizontally at a testing position of a tensile tester, and pressing blocks on the cell, in which the pressing blocks are disposed at two sides of the metal wire, such that the cell will not be pulled up during the test;
   2. Clamping the metal wire at a pull ring of a tension meter that forms an angle of 45° with the cell;
   3. Actuating the tension meter, such that the tension meter moves uniformly along a vertical direction, pulls up the metal wire from the surface of the cell and records the pull data tested, in which the data is averaged to obtain the pull data of the metal wire.
(3) Photoelectric conversion efficiency test

According to the method disclosed in IEC904-1, the solar cell modules manufactured in the above examples and the comparison example are tested with a single flash simulator under standard test conditions (STC): 1000W/m² of light intensity, AMI.5 spectrum, and 25°C. The photoelectric conversion efficiency of each cell is recorded. The testing result is shown in Table 1.

**Table 1**

| Solar cell module | A1 | D1 | A2 | A3 | A4 | A5 |
|---|---|---|---|---|---|---|
| Welding-binding force (N) | 0.22 | <0.1 | 0.35 | 0.38 | 0.41 | 0.46 |
| Photoelectric conversion efficiency (%) | 16.4 | 15.1 | 16.6 | 16.7 | 16.7 | 16.8 |

It can be indicated from Fig. 1 that by comparison between A1-A5 and D1, the welding portions whose projection is broadened, the solar cell module according to the embodiments of the present disclosure has higher welding-binding force, better welding performance, and obtains relatively high photoelectric conversion efficiency.

In the specification, it is to be understood that terms such as "central," "longitudinal," "lateral," "length," "width," "thickness," "upper," "lower," "front," "rear," "left," "right," "vertical," "horizontal," "top," "bottom," "inner," "outer," "clockwise," and "counterclockwise" should be construed to refer to the orientation as then described or as shown in the drawings under discussion. These relative terms are for convenience of description and do not require that the present disclosure be constructed or operated in a particular orientation.

In addition, terms such as "first" and "second" are used herein for purposes of description and are not intended to indicate or imply relative importance or significance or to imply the number of indicated technical features. Thus, the feature defined with "first" and "second" may comprise one or more of this feature. In the description of the present disclosure, "a plurality of' means two or more than two, unless specified otherwise.

In the present disclosure, unless specified or limited otherwise, a structure in which a first feature is "on" or "below" a second feature may include an embodiment in which the first feature is in direct contact with the second feature, and may also include an embodiment in which the first feature and the second feature are not in direct contact with each other, but are contacted via an additional feature formed therebetween. Furthermore, a first feature "on," "above," or "on top of' a second feature may include an embodiment in which the first feature is right or obliquely "on," "above," or "on top of' the second feature, or just means that the first feature is at a height higher than that of the second feature; while a first feature "below," "under," or "on bottom of' a second feature may include an embodiment in which the first feature is right or obliquely "below," "under," or "on bottom of' the second feature, or just means that the first feature is at a height lower than that of the second feature.

Reference throughout this specification to "an embodiment," "some embodiments," or "some examples" means that a particular feature, structure, material, or characteristic described in connection with the embodiment or example is included in at least one embodiment or example of the present disclosure. Thus, these terms throughout this specification do not necessarily refer to the same embodiment or example of the present disclosure. Furthermore, the particular features, structures, materials, or characteristics may be combined in any suitable manner in one or more embodiments or examples.

## Claims

1. A solar cell unit, comprising:
a cell (31) including a cell substrate (311) and a secondary grid line (312) disposed on a front surface of the cell substrate (311); and
a conductive wire (32) intersected and welded with the secondary grid line (312), the secondary grid line (312) having a width in a welding position with the conductive wire (32) greater than a width thereof in a non-welding position,
wherein the secondary grid line (312) preferably has a width in the welding position greater than or equal to a diameter or width of the conductive wire (32); **characterized in that** a binding force between the conductive wire and the cell ranges from 0.2 N to 0.6 N, wherein
the secondary grid line (312) has a width of 0.08-0.24 mm in the welding position, and a width of 0.015-0.03mm in the non-welding position; the width of the secondary grid line (312) is a maximum size in a direction orthogonal to a longitudinal direction of the secondary grid line (312), and/or
wherein the secondary grid line (312) has a height of 0.01-0.03 mm in the welding position, and a height of 0.005-0.01 mm in the non-welding position,
wherein the binding force is tested by placing the cell horizontally at a testing position of a tensile tester, by disposing pressing blocks at two sides of the conductive wire; by clamping the conductive wire at a pull ring of a tension meter that forms an angle of 45° with the cell; and by actuating the tension meter, such that the tension meter moves uniformly along a vertical direction, pulls up the conductive wire from the surface of the cell and records the pull data tested, in which the data is averaged to obtain the pull data of the conductive wire.

2. The solar cell unit according to claim 1, wherein the conductive wire (32) is constituted by a metal wire,
wherein the metal wire is preferably coated with a welding layer at least at a portion where the metal wire is welded with the secondary grid line (312); and the conductive wire (32) is welded with the secondary grid line (312) by the welding layer.

3. The solar cell unit according to claim 1, wherein the secondary grid line (312) is provided with a welding layer, and the conductive wire (32) is welded with the secondary grid line (312) by the welding layer.

4. A solar cell array, comprising a plurality of solar cell units which are the solar cell units according to any one of claims 1 to 3, cells (31) of adjacent cell units being connected by the conductive wires (32A, 32B),
wherein the conductive wire (32A, 32B) is preferably constituted by a metal wire, and the metal wire extends reciprocally between a surface of a first cell (31A) and a surface of a second cell (31B) adjacent to the first cell (31A).

5. The solar cell array according to claim 4, wherein the metal wire extends reciprocally between a front surface of the first cell (31A) and a back surface of the second cell (31B),
wherein a back electrode is preferably disposed on a back surface of the cell substrate (311), and the metal wire is welded with the back electrode of the second cell (31B).

6. The solar cell array according to claim 4, wherein the metal wire extends reciprocally between the front surface of the first cell (31A) and the back surface of the second cell (31B) for 10 to 60 times or
wherein a distance between two adjacent conductive wires (32A, 32B) ranges from 2.5mm to 15mm, or
wherein there is one metal wire, or
wherein the two adjacent conductive wires (32A, 32B) form a U-shape structure or a V-shape structure.

7. The solar cell array according to any one of claims 4 to 6, wherein the metal wire is coated with a welding layer, and a ratio of a thickness of the welding layer and a diameter of the metal wire is (0.02-0.5): 1.

8. The solar cell array according to claim 7, wherein the welding layer contains Sn, and at least one of Bi, In, Ag, Sb, Pb and Zn , preferably Sn, Bi, and at least one of In, Ag, Sb, Pb and Zn.

9. The solar cell array according to claim 7, wherein the welding layer has a thickness of 1 to 100µm.

10. The solar cell array according to claim 2 or 4, wherein the metal wire includes a copper wire.

11. A solar cell module, comprising an upper cover plate, a front adhesive layer, a cell array, a back adhesive layer and a back plate superposed in sequence, the cell array being a solar cell array according to any one of claims 4 to 10.

12. A method for manufacturing a solar cell module, comprising:
providing a cell (31) which includes a cell substrate (311) and a secondary grid line (312) disposed on a front surface of the cell substrate (311);
welding a conductive wire (32) constituted by a metal wire with the secondary grid line (312) to obtain a solar cell unit, in which the secondary grid (312) line has a width in a welding position with the conductive wire (32) greater than a width thereof in a non-welding position;
superposing an upper cover plate, a front adhesive layer, the solar cell unit, a back adhesive layer and a back plate in sequence, in which a front surface of the cell (31) faces the front adhesive layer, a back surface thereof facing the back adhesive layer; and
laminating the superposed layers to obtain the solar cell module wherein a binding force between the conductive wire and the cell ranges from 0.2 N to 0.6 N,
wherein the secondary grid line (312) has a width of 0.08-0.24mm in the welding position, and a width of 0.015-0.03mm in the non-welding position; the width of the secondary grid line (312) is a maximum size in a direction orthogonal to a longitudinal direction of the secondary grid line (312), and/or
wherein the secondary grid line (312) has a height of 0.015-0.03mm in the welding position, and a height of 0.005-0.01mm in the non-welding position,
wherein the binding force is tested by placing the cell horizontally at a testing position of a tensile tester, by disposing pressing blocks at two sides of the conductive wire; by clamping the conductive wire at a pull ring of a tension meter that forms an angle of 45° with the cell; and by actuating the tension meter, such that the tension meter moves uniformly along a vertical direction, pulls up the conductive wire from the surface of the cell and records the pull data tested, in which the data is averaged to obtain the pull data of the conductive wire.

13. The method according to claim 12, wherein there are multiple cells (31A, 31B); and adjacent cells (31A, 31B) are connected by the conductive wires (32A, 32B) to form the cell array according to any one of claims 4 to 9, or
wherein the metal wire extends reciprocally on a surface of the cell (31A, 31B).

## Patentansprüche

1. Solarzelleneinheit, umfassend:
eine Zelle (31), die ein Zellensubstrat (311) und eine Sekundärrasterlinie (312) beinhaltet, die an einer vorderen Oberfläche des Zellensubstrats (311) angeordnet ist; und
einen leitfähigen Draht (32), der sich mit der Sekundärrasterlinie (312) überschneidet und damit verschweißt ist, wobei die Sekundärrasterlinie (312) eine Breite in einer Schweißposition mit dem leitfähigen Draht (32) aufweist, die größer als eine Breite davon in einer Nicht-Schweißposition ist,
wobei die Sekundärrasterlinie (312) vorzugsweise eine Breite in der Schweißposition aufweist, die größer als oder gleich einem Durchmesser oder einer Breite des leitfähigen Drahtes (32) ist; **dadurch gekennzeichnet, dass** eine Bindungskraft zwischen dem leitfähigen Draht und der Zelle in einem Bereich von 0,2 N bis 0,6 N liegt, wobei
die Sekundärrasterlinie (312) eine Breite von 0,08-0,24 mm in der Schweißposition aufweist, und eine Breite von 0,015-0,03 mm in der Nicht-Schweißposition; die Breite der Sekundärrasterlinie (312) eine maximale Größe in einer Richtung orthogonal zu einer Längsrichtung der Sekundärrasterlinie (312) ist, und/oder
wobei die Sekundärrasterlinie (312) eine Höhe von 0,01-0,03 mm in der Schweißposition aufweist, und eine Höhe von 0,005-0,01 mm in der Nicht-Schweißposition,
wobei die Bindungskraft durch Platzieren der Zelle horizontal in eine Prüfposition eines Zugfestigkeitsprüfers geprüft wird, indem Pressblöcke an zwei Seiten des leitfähigen Drahtes angeordnet werden; indem der leitfähige Draht an einen Zugring eines Zugspannungsmessers geklemmt wird, der einen Winkel von 45° mit der Zelle bildet; und indem der Zugspannungsmesser betätigt wird, sodass sich der Zugspannungsmesser gleichförmig entlang einer vertikalen Richtung bewegt, den leitfähigen Draht von der Oberfläche der Zelle abzieht und die geprüften Zugdaten aufzeichnet, wobei die Daten gemittelt werden, um die Zugdaten des leitfähigen Drahtes zu erhalten.

2. Solarzelleneinheit nach Anspruch 1, wobei der leitfähige Draht (32) durch einen Metalldraht gebildet ist,
wobei der Metalldraht vorzugsweise mit einer Schweißschicht mindestens an einem Abschnitt beschichtet ist, an dem der Metalldraht mit der Sekundärrasterlinie (312) verschweißt ist; und der leitfähige Draht (32) durch die Schweißschicht mit der Sekundärrasterlinie (312) verschweißt ist.

3. Solarzelleneinheit nach Anspruch 1, wobei die Sekundärrasterlinie (312) mit einer Schweißschicht bereitgestellt ist, und der leitfähige Draht (32) durch die Schweißschicht mit der Sekundärrasterlinie (312) verschweißt ist.

4. Solarzellenanordnung, umfassend eine Vielzahl von Solarzelleneinheiten, die die Solarzelleneinheiten nach einem der Ansprüche 1 bis 3 sind, wobei Zellen (31) benachbarter Zelleneinheiten durch die leitfähigen Drähte (32A, 32B) verbunden sind,
wobei der leitfähige Draht (32A, 32B) vorzugsweise durch einen Metalldraht gebildet ist, und sich der Metalldraht beiderseitig zwischen einer Oberfläche einer ersten Zelle (31A) und einer Oberfläche einer zur ersten Zelle (31A) benachbarten zweiten Zelle (31B) erstreckt.

5. Solarzellenanordnung nach Anspruch 4, wobei sich der Metalldraht beiderseitig zwischen einer vorderen Oberfläche der ersten Zelle (31A) und einer hinteren Oberfläche der zweiten Zelle (31B) erstreckt,
wobei eine hintere Elektrode vorzugsweise an einer hinteren Oberfläche des Zellensubstrats (311) angeordnet ist, und der Metalldraht mit der hinteren Elektrode der zweiten Zelle (31B) verschweißt ist.

6. Solarzellenanordnung nach Anspruch 4, wobei sich der Metalldraht beiderseitig 10 bis 60 Mal zwischen der vorderen Oberfläche der ersten Zelle (31A) und der hinteren Oberfläche der zweiten Zelle (31B) erstreckt, oder
wobei ein Abstand zwischen zwei benachbarten leitfähigen Drähten (32A, 32B) in einem Bereich von 2,5 mm bis 15 mm liegt, oder
wobei ein Metalldraht vorhanden ist, oder
wobei die beiden benachbarten leitfähigen Drähte (32A, 32B) eine U-förmige Struktur oder eine V-förmige Struktur bilden.

7. Solarzellenanordnung nach einem der Ansprüche 4 bis 6, wobei der Metalldraht mit einer Schweißschicht beschichtet ist, und ein Verhältnis einer Dicke der Schweißschicht und eines Durchmessers des Metalldrahtes (0,02-0,5):1 beträgt.

8. Solarzellenanordnung nach Anspruch 7, wobei die Schweißschicht Sn und mindestens eines von Bi, In, Ag, Sb, Pb und Zn, vorzugsweise Sn, Bi, und mindestens eines von In, Ag, Sb, Pb und Zn enthält.

9. Solarzellenanordnung nach Anspruch 7, wobei die Schweißschicht eine Dicke von 1 bis 100 µm aufweist.

10. Solarzellenanordnung nach Anspruch 2 oder 4, wobei der Metalldraht einen Kupferdraht beinhaltet.

11. Solarzellenmodul, umfassend eine obere Abdeckplatte, eine vordere Haftschicht, eine Zellanordnung, eine hintere Haftschicht und eine hintere Platte der Reihe nach überlagert, wobei die Zellenanordnung eine Solarzellenanordnung nach einem der Ansprüche 4 bis 10 ist.

12. Verfahren zur Herstellung eines Solarzellenmoduls, umfassend:
Bereitstellen einer Zelle (31), die ein Zellensubstrat (311) und eine Sekundärrasterlinie (312) beinhaltet, die auf einer vorderen Oberfläche des Zellensubstrats (311) angeordnet ist;
Verschweißen eines leitfähigen Drahtes (32), der durch einen Metalldraht gebildet ist, mit der Sekundärrasterlinie (312), um eine Solarzelleneinheit zu erhalten, wobei die Sekundärrasterlinie (312) eine Breite in einer Schweißposition mit dem leitfähigen Draht (32) aufweist, die größer als eine Breite davon in einer Nicht-Schweißposition ist;
Überlagern einer oberen Abdeckplatte, einer vorderen Haftschicht, der Solarzelleneinheit, einer hinteren Haftschicht und einer hinteren Platte in Reihenfolge, wobei eine vordere Oberfläche der Zelle (31) der vorderen Haftschicht zugewandt ist, eine hintere Oberfläche davon der hinteren Haftschicht zugewandt ist; und
Laminieren der überlagerten Schichten, um das Solarzellenmodul zu erhalten, wobei eine Bindungskraft zwischen dem leitfähigen Draht und der Zelle in einem Bereich von 0,2 N bis 0,6 N liegt,
wobei die Sekundärrasterlinie (312) eine Breite von 0,08-0,24 mm in der Schweißposition aufweist, und eine Breite von 0,015-0,03 mm in der Nicht-Schweißposition; die Breite der Sekundärrasterlinie (312) eine maximale Größe in einer Richtung orthogonal zu einer Längsrichtung der Sekundärrasterlinie (312) ist, und/oder
wobei die Sekundärrasterlinie (312) eine Höhe von 0,015-0,03 mm in der Schweißposition aufweist, und eine Höhe von 0,005-0,01 mm in der Nicht-Schweißposition,
wobei die Bindungskraft durch Platzieren der Zelle horizontal in eine Prüfposition eines Zugfestigkeitsprüfers geprüft wird, indem Pressblöcke an zwei Seiten des leitfähigen Drahtes angeordnet werden; indem der leitfähige Draht an einen Zugring eines Zugspannungsmessers geklemmt wird, der einen Winkel von 45° mit der Zelle bildet; und indem der Zugspannungsmesser betätigt wird, sodass sich der Zugspannungsmesser gleichförmig entlang einer vertikalen Richtung bewegt, den leitfähigen Draht von der Oberfläche der Zelle abzieht und die geprüften Zugdaten aufzeichnet, wobei die Daten gemittelt werden, um die Zugdaten des leitfähigen Drahtes zu erhalten.

13. Verfahren nach Anspruch 12, wobei mehrere Zellen (31A, 31B) vorhanden sind; und
benachbarte Zellen (31A, 31B) durch die leitfähigen Drähte (32A, 32B) verbunden sind, um die Zellenanordnung nach einem der Ansprüche 4 bis 9 zu bilden, oder
wobei sich der Metalldraht beiderseitig auf einer Oberfläche der Zelle (31A, 31B) erstreckt.

## Revendications

1. Unité de cellule solaire, comprenant :
une cellule (31) incluant un substrat de cellule (311) et une ligne de grille secondaire (312) disposée sur une surface avant du substrat de cellule (311) ; et
un fil conducteur (32) coupé par et soudé avec la ligne de grille secondaire (312), la ligne de grille secondaire (312) présentant une largeur dans une position de soudage avec le fil conducteur (32) supérieure à une largeur de celle-ci dans une position de non-soudage,
dans laquelle la ligne de grille secondaire (312) présente de préférence une largeur dans la position de soudage supérieure ou égale à un diamètre ou une largeur du fil conducteur (32) ; **caractérisée en ce qu'**une force de liaison entre le fil conducteur et la cellule va de 0,2 N à 0,6 N, dans laquelle
la ligne de grille secondaire (312) présente une largeur de 0,08 à 0,24 mm dans la position de soudage, et une largeur de 0,015 à 0,03 mm dans la position de non-soudage, la largeur de la ligne de grille secondaire (312) est une taille maximale dans une direction orthogonale à une direction longitudinale de la ligne de grille secondaire (312), et/ou
dans laquelle la ligne de grille secondaire (312) présente une hauteur de 0,01 à 0,03 mm dans la position de soudage, et une hauteur de 0,005 à 0,01 mm dans la position de non-soudage,
dans laquelle la force de liaison est testée en plaçant la cellule horizontalement au niveau d'une position de test d'un testeur de résistance à la traction, en disposant des blocs de pression des deux côtés du fil conducteur ; en serrant le fil conducteur au niveau d'un anneau de traction d'un tensiomètre qui forme un angle de 45° avec la cellule ; et en actionnant le tensiomètre, de telle sorte que le tensiomètre se déplace uniformément le long d'une direction verticale, tire le fil conducteur vers le haut à partir de la surface de la cellule et enregistre les données de traction testées, les données étant moyennées pour obtenir les données de traction du fil conducteur.

2. Unité de cellule solaire selon la revendication 1, dans laquelle le fil conducteur (32) est constitué d'un fil métallique,
dans laquelle le fil métallique est de préférence revêtu d'une couche de soudage au moins au niveau d'une partie où le fil métallique est soudé avec la ligne de grille secondaire (312) ; et le fil conducteur (32) est soudé avec la ligne de grille secondaire (312) par la couche de soudage.

3. Unité de cellule solaire selon la revendication 1, dans laquelle la ligne de grille secondaire (312) est pourvue d'une couche de soudage, et le fil conducteur (32) est soudé avec la ligne de grille secondaire (312) par la couche de soudage.

4. Réseau de cellules solaires, comprenant une pluralité d'unités de cellules solaires qui sont les unités de cellules solaires selon l'une quelconque des revendications 1 à 3, les cellules (31) d'unités de cellules adjacentes étant reliées par les fils conducteurs (32A, 32B),
dans lequel le fil conducteur (32A, 32B) est de préférence constitué d'un fil métallique, et le fil métallique s'étend réciproquement entre une surface d'une première cellule (31A) et une surface d'une seconde cellule (31B) adjacente à la première cellule (31A).

5. Réseau de cellules solaires selon la revendication 4, dans lequel le fil métallique s'étend réciproquement entre une surface avant de la première cellule (31A) et une surface arrière de la seconde cellule (31B),
dans lequel une électrode arrière est de préférence disposée sur une surface arrière du substrat de cellule (311), et le fil métallique est soudé avec l'électrode arrière de la seconde cellule (31B).

6. Réseau de cellules solaires selon la revendication 4, dans lequel le fil métallique s'étend réciproquement entre la surface avant de la première cellule (31A) et la surface arrière de la seconde cellule (31B) 10 à 60 fois ou
dans lequel une distance entre deux fils conducteurs (32A, 32B) adjacents va de 2,5 mm à 15 mm, ou
dans lequel il existe un seul fil métallique, ou
dans lequel les deux fils conducteurs (32A, 32B) adjacents forment une structure en U ou une structure en V.

7. Réseau de cellules solaires selon l'une quelconque des revendications 4 à 6, dans lequel le fil métallique est revêtu d'une couche de soudage, et un rapport d'une épaisseur de la couche de soudage et d'un diamètre du fil métallique est de (0,02-0,5):1.

8. Réseau de cellules solaires selon la revendication 7, dans lequel la couche de soudage contient du Sn, et au moins un parmi Bi, In, Ag, Sb, Pb et Zn, de préférence, Sn, Bi, et au moins un parmi In, Ag, Sb, Pb et Zn.

9. Réseau de cellules solaires selon la revendication 7, dans lequel la couche de soudage présente une épaisseur de 1 à 100 µm.

10. Réseau de cellules solaires selon la revendication 2 ou 4, dans lequel le fil métallique inclut un fil de cuivre.

11. Module de cellules solaires, comprenant une plaque de couverture supérieure, une couche adhésive avant, un réseau de cellules, une couche adhésive arrière et une plaque arrière superposés en séquence, le réseau de cellules étant un réseau de cellules solaires selon l'une quelconque des revendications 4 à 10.

12. Procédé de fabrication d'un module de cellules solaires, comprenant :
la fourniture d'une cellule (31) qui inclut un substrat de cellule (311) et une ligne de grille secondaire (312) disposée sur une surface avant du substrat de cellule (311) ;
le soudage d'un fil conducteur (32) constitué d'un fil métallique avec la ligne de grille secondaire (312) pour obtenir une unité de cellule solaire, la ligne de grille secondaire (312) présentant une largeur dans une position de soudage avec le fil conducteur (32) supérieure à une largeur de celle-ci dans une position de non-soudage ;
la superposition d'une plaque de couverture supérieure, d'une couche adhésive avant, de l'unité de cellule solaire, d'une couche adhésive arrière et d'une plaque arrière en séquence, une surface avant de la cellule (31) faisant face à la couche adhésive avant, une surface arrière de celle-ci faisant face à la couche adhésive arrière ; et
la stratification des couches superposées pour obtenir le module de cellules solaires, dans lequel une force de liaison entre le fil conducteur et la cellule va de 0,2 N à 0,6 N,
dans lequel la ligne de grille secondaire (312) présente une largeur de 0,08 à 0,24 mm dans la position de soudage, et une largeur de 0,015 à 0,03 mm dans la position de non-soudage, la largeur de la ligne de grille secondaire (312) est une taille maximale dans une direction orthogonale à une direction longitudinale de la ligne de grille secondaire (312), et/ou
dans lequel la ligne de grille secondaire (312) présente une hauteur de 0,015 à 0,03 mm dans la position de soudage, et une hauteur de 0,005 à 0,01 mm dans la position de non-soudage,
dans lequel la force de liaison est testée en plaçant la cellule horizontalement au niveau d'une position de test d'un testeur de résistance à la traction, en disposant des blocs de pression des deux côtés du fil conducteur ; en serrant le fil conducteur au niveau d'un anneau de traction d'un tensiomètre qui forme un angle de 45° avec la cellule ; et en actionnant le tensiomètre, de telle sorte que le tensiomètre se déplace uniformément le long d'une direction verticale, tire le fil conducteur vers le haut à partir de la surface de la cellule et enregistre les données de traction testées, les données étant moyennées pour obtenir les données de traction du fil conducteur.

13. Procédé selon la revendication 12, dans lequel il existe de multiples cellules (31A, 31B) ; et des cellules (31A, 31B) adjacentes sont connectées par les fils conducteurs (32A, 32B) pour former le réseau de cellules selon l'une quelconque des revendications 4 à 9, ou
dans lequel le fil métallique s'étend réciproquement sur une surface de la cellule (31A, 31B).
